# EUROPEAN PATENT APPLICATION

(11) **EP 4 790 910 A2**
(43) Date of publication of application: **12.08.2026**
(21) Application number: 26151377.4
(22) Date of filing: 12.01.2026
(51) Int. Cl.: H04B 5/48, H04B 5/73, H04B 5/77, G06K 7/10

(54) **NEAR-FIELD COMMUNICATION METHOD, RADIO FREQUENCY CHIP, ELECTRONIC DEVICE, AND COMPUTER-READABLE STORAGE MEDIUM**

(30) Priority: 16.01.2025 CN 202510075901
(71) Applicant: GUANGDONG OPPO MOBILE TELECOMMUNICATIONS CORP., LTD., Dongguan, Guangdong 523860 (CN)
(72) Inventor: CHEN, Huaxing, Dongguan, Guangdong, 523860 (CN)
(74) Representative: Novagraaf Technologies

(57) **Abstract**

A near-field communication method, a radio frequency chip (10), an electronic device (1), and a computer-readable storage medium are disclosed. The method includes: transmitting (S201) a carrier signal of a preset frequency, the preset frequency is different from a near-field communication frequency; receiving (S202) a radio frequency signal within a near-field communication range; and performing (S203), in a case where the radio frequency signal includes a signal from a near-field communication device within the near-field communication range in response to the transmitted carrier signal, near-field communication with the near-field communication device.

## Description

### TECHNICAL FIELD

Some embodiments of the present disclosure relate to the technical field of near-field communication, and in particular to a near-field communication method, a radio frequency chip, an electronic device, and a computer-readable storage medium.

### BACKGROUND

Many electronic devices, such as mobile phones, tablets, etc., are equipped with an NFC (Near-Field Communication) function. The electronic devices may interact with each other based on NFC for purpose such as file sharing, application relay, etc.

The applicant found that the response speed of traditional electronic devices may be slow when performing the NFC interaction.

### SUMMARY

To address the above technical problems, some embodiments of the present disclosure provide a near-field communication method, a radio frequency chip, an electronic device, and a computer-readable storage medium, which can improve the response speed of the near-field communication.

In a first aspect, some embodiments of the present disclosure may provide a near-field communication method. The near-field communication method may include: transmitting a carrier signal of a preset frequency, the preset frequency is different from a near-field communication frequency; receiving a radio frequency signal within a near-field communication range; and performing, in a case where the radio frequency signal includes a signal from a near-field communication device within the near-field communication range in response to the transmitted carrier signal, near-field communication with the near-field communication device.

In a second aspect, some embodiments of the present disclosure may provide a radio frequency chip. The radio frequency chip may be configured with a first terminal and a second terminal. The radio frequency chip may include: a multi-stage frequency divider, an input terminal of the multi-stage frequency divider is connected to the first terminal of the radio frequency chip to receive an external clock signal, the multi-stage frequency divider includes a first frequency divider at a stage and a second frequency divider at another different stage, a frequency of a first clock signal output by the first frequency divider matches a preset frequency, and a frequency of a second clock signal output by the second frequency divider matches a near-field communication frequency; a first switching module, a first input terminal of the first switching module is connected to the first frequency divider and a second input terminal of the first switching module is connected to the second frequency divider; and a processing circuit, an input terminal of the processing circuit is connected to an output terminal of the first switching module, an output terminal of the processing circuit is connected to the second terminal of the radio frequency chip, and the processing circuit is configured to support outputting the carrier signal of the preset frequency based on the first clock signal, support receiving a radio frequency signal within a near-field communication range, and support outputting, in a case where the radio frequency signal includes a signal from a near-field communication device within the near-field communication range in response to the carrier signal, a near-field communication signal based on the second clock signal. The near-field communication signal is configured for near-field communication with the near-field communication device.

In a third aspect, some embodiments of the present disclosure may provide an electronic device. The electronic device may include the above radio frequency chip; or the electronic device is configured to execute operations of the above near-field communication method.

In a fourth aspect, some embodiments of the present disclosure may provide a computer-readable storage medium. The computer-readable storage medium may store a computer program. When executed by a processor, the computer program may be configured to execute the operations of the above near-field communication method.

In the above near-field communication method, near-field communication apparatus, radio frequency chip, electronic device, and computer-readable storage medium, by transmitting a carrier signal with a frequency different from the near-field communication frequency and receiving a radio frequency signal, it is possible to detect whether a near-field communication device is approaching within the near field communication range. In a case where a near-field communication device is identified as being within the near-field communication range, the near-field communication may be performed with the near-field communication device. Since the frequency of the carrier signal is different from the frequency of the near-field communication signal, the frequency of the carrier signal may not be identified as the near-field communication signal by the near-field communication device within the near-field communication range. Therefore, the transmission of an NFC field intensity and an NFC command being performed by the near-field communication device may not be interrupted, and there is no need to wait for a time slot, thereby achieving high efficiency and fast response speed of the near-field communication.

### BRIEF DESCRIPTION OF THE DRAWINGS

To describe the technical solutions in the embodiments of the present disclosure more clearly, the following will briefly introduce the drawings required for describing the embodiments of the present disclosure or the related art. Obviously, the drawings described hereafter are related to some embodiments of the present disclosure. Those skilled in the art may further obtain other drawings without any creative work according to these drawings.
FIG. 1 is a view illustrating an application environment of a near-field communication method in one or more embodiments.
FIG. 2 is a first flowchart of a near-field communication method in one or more embodiments.
FIG. 3 is a second flowchart of the near-field communication method in one or more embodiments.
FIG. 4 is a third flowchart of the near-field communication method in one or more embodiments.
FIG. 5 is a fourth flowchart of the near-field communication method in one or more embodiments.
FIG. 6 is a fifth flowchart of the near-field communication method in one or more embodiments.
FIG. 7 is a sixth flowchart of the near-field communication method in one or more embodiments.
FIG. 8 is a structural diagram of a near-field communication apparatus in one or more embodiments.
FIG. 9 is an internal structural diagram of a radio frequency chip in one or more embodiments.
FIG. 10 is a first structural diagram of an electronic device in one or more embodiments.
FIG. 11 is a second structural diagram of the electronic device in one or more embodiments.
FIG. 12 is a third structural diagram of the electronic device in one or more embodiments.
FIG. 13 is a fourth structural diagram of the electronic device in one or more embodiments.
FIG. 14 is a fifth structural diagram of the electronic device in one or more embodiments.

### DETAILED DESCRIPTION

In order to make the objectives, technical solutions, and advantages of the present disclosure clearer, the following further describes the present disclosure in detail with reference to the accompanying drawings and embodiments. It should be understood that the embodiments described herein are only used to explain the present disclosure and are not intended to limit the present disclosure.

In the related art, there is no unified standard NFC interaction command between different manufacturers, especially between Android devices and iOS devices. When these electronic devices perform NFC interaction, these electronic devices cannot identify the peer device from different manufacturers, and thereby failing to trigger the corresponding NFC interaction process.

To achieve the NFC interaction, in exemplary techniques, in a case where two mobile phones perform the NFC interaction, one mobile phone may enter a card emulation mode (a passive working mode in which the electronic device does not actively emit an NFC field intensity (the electromagnetic field intensity generated by the electronic device during the near-field communication process) and an NFC command (data and control signals exchanged between the electronic devices during the NFC process; via the NFC command, the electronic devices may execute operations such as initiating communication, reading data, writing data, etc.), and respond after receiving the NFC field intensity and the NFC command from the peer device). The peer device (another mobile phone) may enter a card reading mode (an active working mode in which the peer device actively emits the NFC field intensity and the NFC command). In a case where the peer device reads content in a pre-configured NDEF (NFC Data Exchange Format) tag, the peer device may enter a preset NFC tap-to-interact function.

However, when performing a tap-to-interact between the mobile phone and a device that only supports the card emulation function (such as a tablet, etc.), the mobile phone may only operate in the card reading mode at this time. To enable the NFC interaction between the mobile phone and the device that only supports the card emulation function, while also supporting the NFC interaction between the mobile phone and the devices such as other mobile phones that equipped with both the card emulation function and the card reading function, the mobile phone cannot remain in a single mode and needs to accommodate both working modes.

In exemplary techniques, to achieve this function, the electronic device may send a Type V command (command that does not cause the electronic device to enter the card emulation mode) to detect whether another near-field communication device (such as a mobile phone, tablet, metal, etc.) is approaching. In a case where the electronic device detects that another near-field communication device is approaching, the electronic device may turn off or deactivate the NFC field intensity and the NFC command, enter the card emulation mode, and wait for a period of time. In a case where the NFC command from the another near-field communication device are received during the waiting period, the electronic device may enter the NFC tap-to-interact process. If no command from the another near-field communication device is received during the waiting time, the another near-field communication device may be identified as the NFC device that only supports the card emulation function, such as a tablet or metal object. In this case, the electronic device may start to send Type A/B/F commands to perform the NFC tap-to-interact with the near-field communication device that only supports the card emulation function.

Since the electronic device sends the Type V command, the near-field communication device that receives the Type V command may identify the existence of an external NFC card reading device. According to the NFC Forum specifications (a series of technical standards and specifications formulated by the NFC Forum Organization), when a near-field communication device receives an external NFC field intensity, the near-field communication device needs to turn off the NFC field intensity and the NFC command, and wait until next time slot (the time slot has a certain duration, for example, about 800ms) to transmit the NFC field intensity. During this time slot, the electronic device and the near-field communication device that received the Type V command may not transmit the NFC field intensity and the NFC command, which prolongs the NFC tap-to-interact time and results in a slow response speed of the near-field communication.

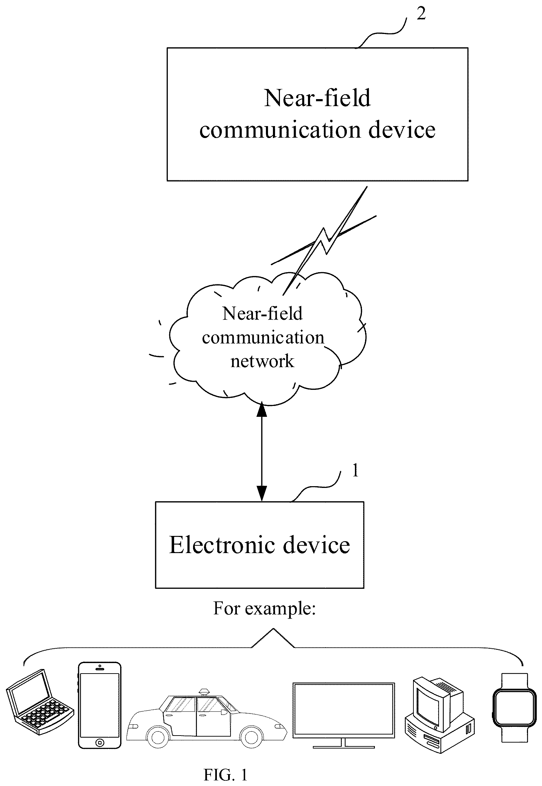

The near-field communication method provided in some embodiments of the present disclosure may be applied to the application environment as shown in FIG. 1. The electronic device 1 may communicate with a near-field communication device 2 via a network. The electronic device 1 may transmit a carrier signal of a preset frequency, the preset frequency may be different from a near-field communication frequency. In a case where there is a near-field communication device 2 in a near-field communication range, a radio frequency signal received by the electronic device 1 within the near-field communication range may be affected. Based on this property, whether the near-field communication device exists within the near-field communication range may be determined based on the radio frequency signal. In a case where the near-field communication device 2 exists within the near-field communication range, the electronic device 1 may perform the near-field communication with the near-field communication device 2. The electronic device 1 may be, but is not limited to, various personal computers, laptops, smartphones, tablets, Internet-of-Things (IoT) devices, and portable wearable devices. The IoT devices may be smart speakers, smart TVs, smart air conditioners, smart vehicle-mounted devices, projection devices, etc. The portable wearable devices may be smart watches, smart bracelets, head-mounted devices, etc. The head-mounted devices may be virtual reality (VR) devices, augmented reality (AR) devices, smart glasses, etc. The near-field communication device 2 may be metal parts and devices including, but is not limited to, various personal computers, laptops, smartphones, tablets, Internet of Things (IoT) devices, portable wearable devices, subway gates, bus card readers, access control systems, POS (Point of sales) machines, etc. The IoT devices may be smart speakers, smart TVs, smart air conditioners, smart vehicle-mounted devices, projection devices, etc. The portable wearable devices may be smart watches, smart bracelets, head-mounted devices, etc. The head-mounted devices may be virtual reality (VR) devices, augmented reality (AR) devices, smart glasses, etc.

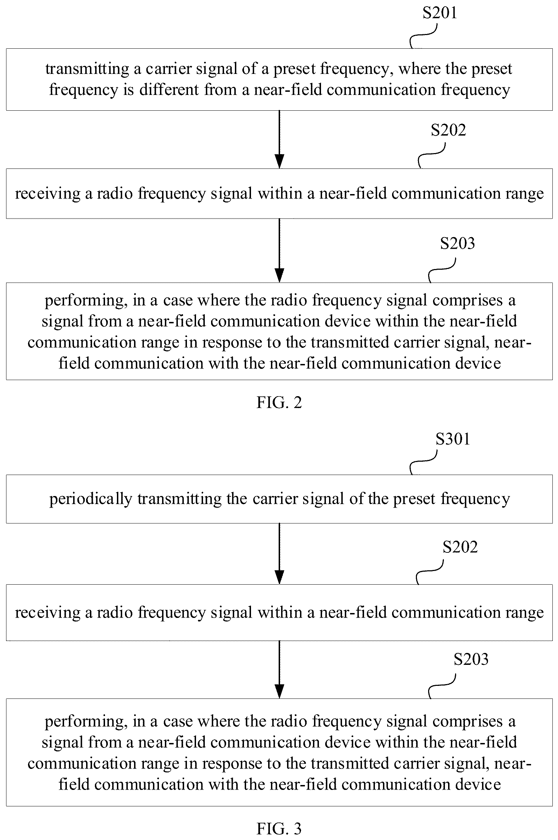

In one or more embodiments, as shown in FIG. 2, a near-field communication method is provided. The method may include the blocks or operations as follow.

At block S201, a carrier signal of a preset frequency may be transmitted, and the preset frequency may be different from a near-field communication frequency.

The near-field communication may be a short-range wireless communication technology. The near-field communication frequency may be 13.56 MHz. The carrier signal may be an electric wave transmitted on a communication link and configured to transmit information. The frequency of the carrier signal is different from the near-field communication frequency. The transmitted carrier signal may not be identified as a near-field communication signal by the near-field communication device within the near-field communication range, thus reducing the possibility of interrupting the NFC polling process or other processes which is being performed by the near-field communication device.

The electronic device may provide an excitation current to achieve radiation of the NFC signal (the near-field communication signal) along a transmission path of the excitation current, thereby performing near-field communication. The electronic device may execute the near-field communication command related to file transmission to the near-field communication device within the near-field communication range, to achieve the near-field communication with the near-field communication device.

At block S202, a radio frequency signal within a near-field communication range may be received. The radio frequency signal may at least include the signal received by the electronic device in the magnetic field excited by the carrier signal in a case where the carrier signal is transmitted. The radio frequency signals received by the electronic device may differ in two cases: in a first case, there is a near-field communication device within the near-field communication range; and in a second case, there is no near-field communication device within the near-field communication range. Therefore, by monitoring the received radio frequency signal, the electronic device may identify whether a near-field communication device has entered the near-field communication range thereof.

At block S203, in a case where the radio frequency signal includes a signal from the near-field communication device within the near-field communication range in response to the transmitted carrier signal, near-field communication with the near-field communication device may be performed.

In some embodiments, in a case where the radio frequency signal includes a signal from the near-field communication device within the near-field communication range in response to the transmitted carrier signal, near-field communication with the near-field communication device may be performed. In some embodiments, in a case where the near-field communication device exists within the near-field communication range, the carrier signal emitted by the electronic device may be reflected by the near-field communication device and then received by the electronic device. In some embodiments, in a case where the near-field communication device exists within the near-field communication range, a signal may be transmitted by (or generated by) the near-field communication device in response to the transmitted carrier signal and then received by the electronic device. In the above cases, the electronic device may perform the near-field communication with the near-field communication device. The mechanism of the near-field communication between the electronic device and the near-field communication device may be determined according to the device types and operation states of the electronic device and the near-field communication device, and will not be described in detail here.

In some embodiments, in a case where the electronic device needs to perform the NFC, for example, in a trigger scenario of the NFC tap-to-interact, the electronic device may emit the carrier signal of the preset frequency and receive the radio frequency signal in the magnetic field environment and excited by the carrier signal. In a case where the received radio frequency signal includes a signal from the near-field communication device in response to the transmitted carrier signal, it may indicate that the near-field communication device exists within the near-field communication range, and the electronic device may perform the near-field communication with the near-field communication device. Since the frequency of the transmitted carrier signal is different from that of the near-field communication signal, the possibility of the carrier signal being identified as a near-field communication signal by the near-field communication device within the near-field communication range may be reduced. Therefore, the risk of interrupting the NFC field intensity and the command transmission being performed by the near-field communication device may be reduced. Compared with the method of sending the Type V command in the related art, there may be no need to wait for a time slot, the efficiency of NFC interaction between the electronic device and the near-field communication device may be high, and the response speed may be fast.

In addition, the near-field communication method provided in some embodiments of the present disclosure may be applied to the NFC between the devices from different manufacturers, and even supports the NFC between Android devices and iOS devices, thus having a wide range of applications.

The near-field communication method provided in some embodiments of the present disclosure does not require forcing the electronic device itself into the card emulation mode when the near-field communication device exists within the near-field communication range. Therefore, the near-field communication method not only supports NFC with devices such as mobile phones that support both the card emulation function and the card reading function, but also supports NFC between the electronic device and the near-field communication device that only supports the card emulation function.

In some embodiments, identifying whether the received radio frequency signal includes a signal from the near-field communication device in response to the transmitted carrier signal may be achieved by comparing the difference between the transmitted carrier signal and the received radio frequency signal, or by comparing the difference between the received radio frequency signals in a case with a near-field communication device and a case without a near-field communication device.

In one or more embodiments, the carrier signal may be an unmodulated carrier signal.

The unmodulated carrier signal may be a carrier signal that does not carry information. For example, the unmodulated carrier signal may be a sinusoidal signal.

In one or more embodiments, when the NFC is needed to be performed, instead of sending the Type V command of NFC, the unmodulated carrier signal with a non-near-field communication frequency may be transmitted or emitted. The unmodulated carrier signal may identify whether the near-field communication device is approaching, but the unmodulated carrier signal may not be identified as the NFC signal by the peer near-field communication device. Therefore, the transmission of the NFC field intensity and the NFC command being performed by the near-field communication device may not be interrupted. Compared with the solution of sending the Type V command to achieve the NFC, there is no need to wait for a time slot, thereby achieving high efficiency and fast response speed of the near-field communication.

In some embodiments, by transmitting the unmodulated carrier signal, it is also possible to reduce the occurrence of negative impacts on other functions of the near-field communication device. That is, the near-field communication method provided in some embodiments of the present disclosure may achieve fast NFC while reducing the occurrence of the negative impacts on other functions being executed by the near-field communication device, thereby improving performance stability of the electronic device.

In some embodiments, as shown in FIG. 3, the block S201 of transmitting the carrier signal of the preset frequency may include the block or the operation as follow.

At block S301, the carrier signal of the preset frequency may be periodically emitted or transmitted. By periodically emitting the carrier signal, while detecting whether a near-field communication device has entered the near-field communication range, other functions may be implemented during time slots between emitting the carrier signals.

In some embodiments, in a case where the carrier signal of the preset frequency is transmitted, the card emulation function is retained, thereby supporting card reading actions from other devices on the electronic device.

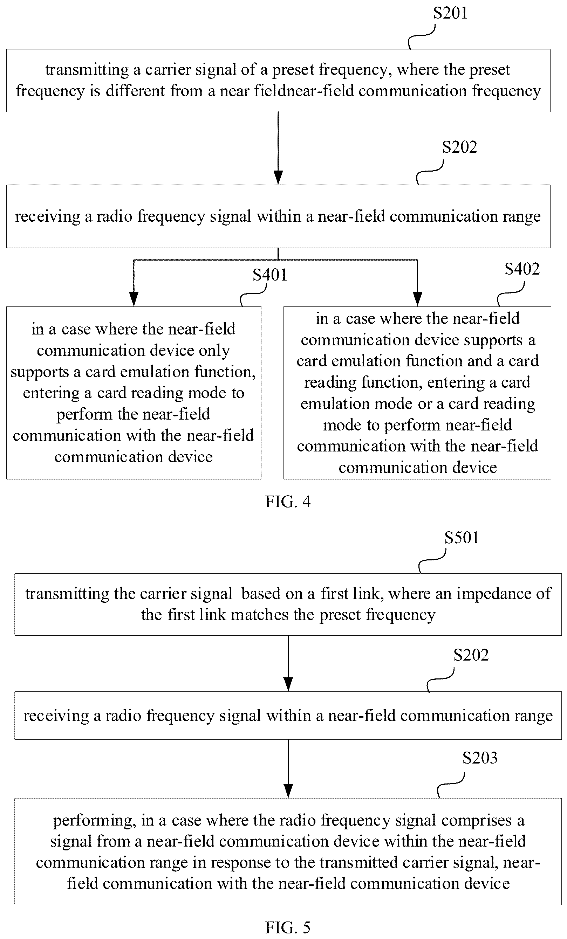

In some embodiments, as shown in FIG. 4, in a case where the near-field communication device only supports the card emulation function, the block S203 of performing the near-field communication with the near-field communication device may include the block or the operation as follow.

At block S401, a card reading mode may be entered to perform the near-field communication with the near-field communication device.

A user may bind entity cards such as bus cards, subway cards, bank cards, access cards, etc., to the near-field communication device such as a tablet. The information of the entity card may be read, for example, through an NFC chip and then be written into the near-field communication device, forming an NFC electronic card corresponding to the entity card in the near-field communication device. After the binding, the user may perform card swiping through the NFC electronic card in the near-field communication device, thereby realizing the function of the entity card through the near-field communication device. The aforementioned function may be configured as the card emulation function, which may provide convenience for the user's life.

In a case where the near-field communication device only supports the card emulation function, the electronic device may only enter the card reading mode. In this case, the electronic device may act as a card reader to achieve the NFC between the electronic device and the near-field communication device.

In some embodiments, in a case where the near-field communication device only supports the card emulation function, the electronic device may enter the card reading mode and retain the card emulation function.

In some embodiments, as shown in FIG. 4, in a case where the near-field communication device supports both the card emulation function and the card reading function, the block S203 of performing the near-field communication with the near-field communication device may include the block or the operation as follow.

At block S402, a card emulation mode or a card reading mode may be entered, to perform the near-field communication with the near-field communication device.

The electronic device may be configured to support both the card emulation function and the card reading function. When the near-field communication device supports both the card emulation function and the card reading function, the electronic device and the near-field communication device may perform the near-field communication based on the NFC Forum specifications. For example, both the electronic device and the near-field communication device may adopt a polling mechanism between the card reading mode and the card emulation mode. The electronic device may switch between the card reading mode and the card emulation mode at a first polling time interval, and the near-field communication device may switch between the card reading mode and the card emulation mode at a second polling time interval. During the polling process of the electronic device and the near-field communication device, it may be the card reading mode of the electronic device to meet the card emulation mode of the near-field communication device, or it may be the card emulation mode of the electronic device to meet the card reading mode of the near-field communication device, thereby achieving the near-field communication between the electronic device and the near-field communication device. Therefore, in a case where the near-field communication device supports both the card emulation function and the card reading function, the electronic device may enter the card emulation mode or the card reading mode to establish near-field communication with the near-field communication device.

It should be noted that, the implementation of the electronic device entering the card emulation mode or the card reading mode in a case where the near-field communication device supports both the card emulation function and the card reading function may also be understood, according to the data or information of the NFC chip in the electronic device and the NFC Forum specifications, and will not be described in detail here.

In some embodiments, the preset frequency may be a frequency outside a preset frequency range, and the preset frequency range may be a frequency range that triggers the near-field communication device to interrupt a transmission of a near-field communication signal.

The near-field communication device may treat signals within the preset frequency range as NFC signals and respond accordingly, thereby interrupting ongoing near-field communication signal transmission action of the near-field communication device and entering a waiting state. By selecting the frequency outside the preset frequency range as the preset frequency of the carrier signal, it may be ensured that in a case where the near-field communication device entering the near-field communication range receives the carrier signal, it may not be determined that there is an external NFC field intensity. In this case, the near-field communication device may not interrupt the signal transmission of the NFC, and the electronic device and the near-field communication device may quickly establish a near-field communication link, thereby improving the response efficiency of the NFC.

For example, in a case, tests on several mobile phones found that in a case where the frequency of the unmodulated carrier signal exceeds a certain range, the mobile phones may no longer respond to these signals. Taking a mobile phone a in Table 1 as an example, in a case where the frequency of the external signal received by the mobile phone a is between 11 MHz and 17.5 MHz, the mobile phone a may determine that there is an external NFC field intensity and then turn off the transmission of the NFC signal. In a case where the frequency of the external signal received by mobile phone a is higher than 17.5 MHz or lower than 11 MHz, the mobile phone a may determine that there is no external NFC field intensity, that is, there is no external NFC signal. In this case, the mobile phone a may not interrupt the transmission of the NFC signal and still perform signal transmission according to the logic of the mobile phone a, thereby reducing the waste of the time slots and improving the response speed of the NFC interaction.

**Table 1**

| | Determination of the NFC field intensity emitted by the mobile phone | |
|---|---|---|
| Phone Name | Upper Limit (MHz) | Lower Limit (MHz) |
| Mobile phone a | 17.5 | 11.0 |
| Mobile phone b | 18.7 | 8.9 |
| Mobile phone c | 18.8 | 10.0 |
| Mobile phone d | 23.3 | 6.9 |

In some embodiments, the preset frequency may be multiple times the near-field communication frequency. The multiple times may refer to two times or more. In a case where the preset frequency is multiple times the near-field communication frequency, the carrier signal may be a multiple-frequency signal of the near-field communication signal. By configuring a multiple-frequency signal of the near-field communication signal, the generation of the carrier signal based on the near-field communication signal may be convenient, while reducing the hardware cost and design cost.

In some embodiments, the preset frequency may be twice the near-field communication frequency. In this case, the carrier signal may be a double-frequency signal of the near-field communication signal. The frequency of the near-field communication signal may be 13.56 MHz. In this case, the carrier signal may be a carrier signal with a frequency of 27.12 MHz. In some embodiments, an unmodulated carrier signal of 27.12 MHz may be used. By transmitting the unmodulated carrier signal of 27.12 MHz, the frequency signal is configured to detect whether other near-field communication devices such as mobile phones or tablets are approaching. The unmodulated carrier signal may not affect the approaching near-field communication device, thereby reducing the waste of the time slots of the near-field communication device and accelerating the communication speed of the NFC between the electronic device and the near-field communication device.

In some embodiments, as shown in FIG. 5, the block S201 of transmitting the carrier signal of the preset frequency may include the block or operation as follow.

At block S501, the carrier signal may be transmitted or emitted based on a first link, and an impedance of the first link may match the preset frequency.

The link may refer to a communication path in the electronic device during the signal transmission process. The link may include components such as a matching circuit, an antenna, etc., to support the transmission of radio frequency signals. A PA (Power amplifier) may be arranged on the link supporting the signal transmission to achieve power amplification of the radio frequency signal. An LNA (Low Noise Amplifier) may be arranged on the link supporting signal reception to improve the quality of signal reception. The first link may at least support the transmission of the carrier signal.

The near-field communication method provided in some embodiments of the present disclosure, by conducting the first link whose impedance matches the preset frequency, the transmission of the carrier signal may be supported. Therefore, the performance of the carrier signal transmission may be ensured, thereby improving the reliability and stability of the implementation of the near-field communication method.

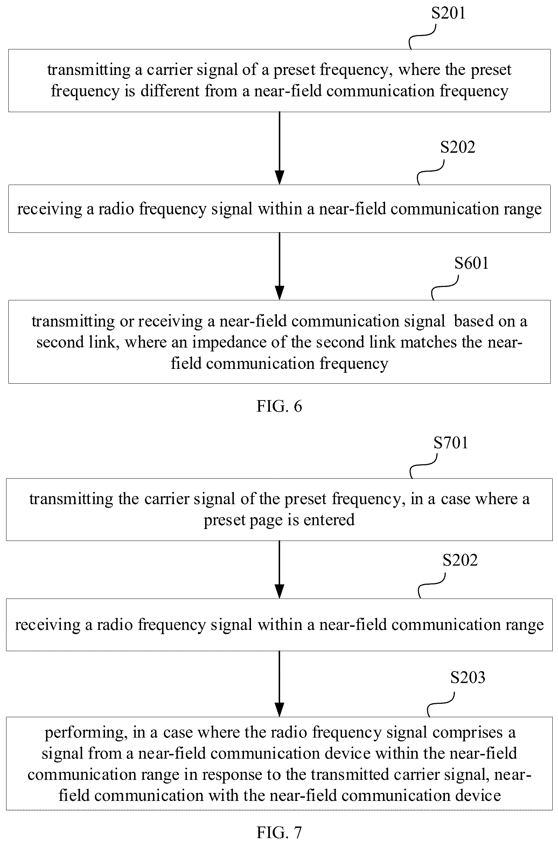

In some embodiments, as shown in FIG. 6, the block S203 of performing the near-field communication with the near-field communication device may include the block or operation as follow.

At block S601, a near-field communication signal may be transmitted or received based on a second link, and an impedance of the second link may match the near-field communication frequency.

The implementation of the block S601 of transmitting or receiving the near-field communication signal based on the second link, may be understood in two cases: in a first case, the near-field communication device only supports the card emulation function; and in a second case, the near-field communication device supports both the card emulation function and the card reading function.

The near-field communication method provided in some embodiments of the present disclosure, by conducting the second link whose impedance matches the near-field communication frequency, supports the transmission and reception of near-field communication signals. Therefore, the reliability and stability of the signal transmission of the NFC during the near-field communication process between the electronic device and the near-field communication device may be ensured, thereby improving the quality of near-field communication.

In some embodiments, as shown in FIG. 7, the block S201 of transmitting the carrier signal of a preset frequency may include the block or operation as follow.

At block S701, the carrier signal of the preset frequency may be transmitted or emitted, in a case where a preset page is entered.

The preset page may be a pre-agreed page that can represent the user's need for NFC. For example, the preset page may be an NFC tap interface, an NFC sharing page, etc.

The near-field communication method provided in some embodiments of the present disclosure, by predefining the trigger condition for the carrier signal, the carrier signal of the preset frequency may be transmitted automatically in a case where the preset page is entered, enabling the detection of the near-field communication device within the near-field communication range, binding to the user's need and significantly enhancing the convenience of the NFC for the user during the NFC tap-to-interact scenario.

To better introduce the implementation process of the near-field communication method provided in some embodiments of the present disclosure, some embodiments are illustrated, but it must be emphasized that the embodiments does not limit the actual protection scope of the present disclosure.

In a case where the electronic device enters a sharing page, the transmission of the near-field communication signal of 13.56 MHz may be stopped. The electronic device may periodically emit the unmodulated carrier signal of 27.12 MHz. The electronic device may retain the card emulation function;

In a case where the electronic device detects the approaching of a metallic object through via the unmodulated carrier signal of 27.12 MHz, the electronic device may return to the NFC working mode, and transmit the 13.56 MHz near-field communication signal (enters the card reading mode). The electronic device may retain the card emulation function.

In a case where the near-field communication device approaching the electronic device is a mobile phone, the electronic device and the mobile phone may interact with each other through the NFC. One of the electronic device and the mobile phone may act as a card emulation (enter the card emulation mode), and the other may act as a card reader (enter the card reading mode), which may be determined according to the current NFC mechanism.

In a case where the near-field communication device approaching the electronic device is a tablet computer, the electronic device may act as a card reader and enter the card reading mode, and the tablet computer may act as a card emulation and enter the card emulation mode, thereby achieving the near-field communication between the electronic device and the tablet computer.

By executing the near-field communication method of some embodiments of the present disclosure, faster NFC tap-to-interact between the electronic device and the near-field communication device may be achieved. The traditional solution may take about a time of 1.5s for the NFC tap-to-interact. However, the solution provided in some embodiments of the present disclosure may achieve the near-field communication between the electronic device and the near-field communication device within 700 ms, thereby significantly improving the response speed.

In some embodiments, the preset frequency may be a frequency less than or equal to 5 times the near-field communication frequency (i.e., less than or equal to 67.8 MHz), to reduce the risk of the increasing cost of modifying the peripheral circuit and the matching circuit caused by the preset frequency being too far from the near-field communication frequency. That is, by selecting a frequency less than or equal to 5 times the near-field communication frequency and outside or beyond the preset frequency range as the preset frequency for guiding the generation of the carrier signal, it is possible to improve the response speed of the near-field communication while taking the hardware cost into account.

The near-field communication method provided in some embodiments of the present disclosure may add a transmission frequency band (preset frequency band) to existing electronic devices supporting the NFC function. The transmission frequency band may be configured to detect whether there is another NFC device approaching, without interfering with the normal NFC polling of other near-field communication devices, thereby accelerating the response speed between two devices.

It should be understood that, the blocks or operations in the flowcharts of the various embodiments described above are shown in sequence as indicated by the arrows, however, these blocks or operations are not necessarily performed in the order indicated by the arrows. Unless explicitly stated herein, the execution of these blocks or operations is not strictly limited in order, and these blocks or operations may be performed in other orders. Moreover, at least a part of the blocks or operations in the flowcharts of the various embodiments described above may include multiple blocks or multiple stages. These blocks or stages are not necessarily performed at the same time, but may be performed at different times. The execution order of these blocks or stages is not necessarily sequential, but may be performed in rotation or alternately with other blocks or at least a part of the blocks or stages of other blocks.

Based on the same inventive concept, some embodiments of the present disclosure also provide a near-field communication apparatus for implementing the above-mentioned near-field communication method. The implementation scheme to solve problem provided by the near-field communication apparatus may be similar to the implementation scheme described in the above method. Therefore, limitations in some embodiments of the near-field communication apparatus provided below may be referred to the limitations on the near-field communication method above, and are not repeated here.

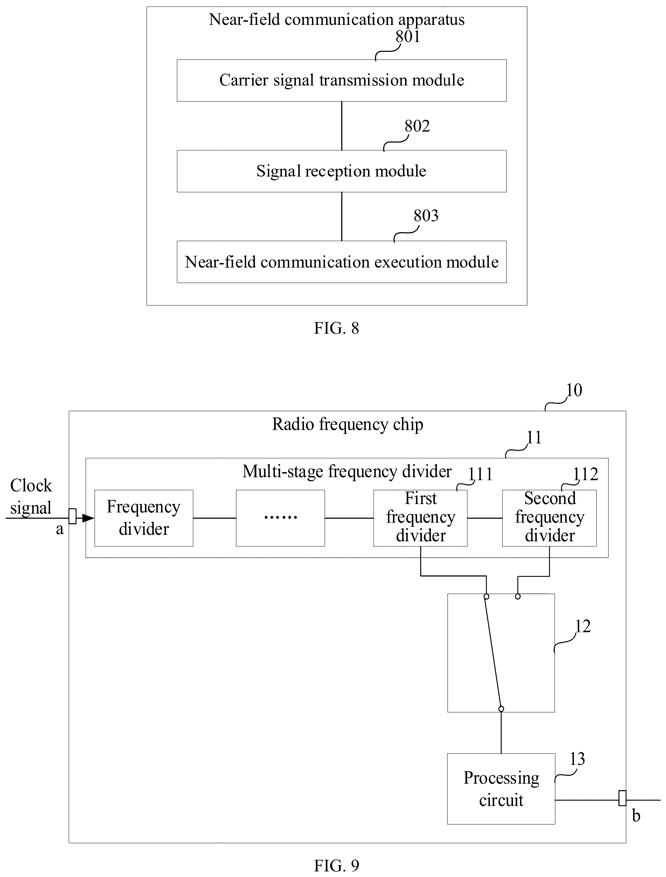

In some embodiments, as shown in FIG. 8, a near-field communication apparatus is provided. The near-field communication apparatus may include a carrier signal transmission module 801, a signal reception module 802, and a near-field communication execution module 803.

The carrier signal transmission module 801 may be configured to emit a carrier signal of a preset frequency, and the preset frequency may be different from a near-field communication frequency.

The signal reception module 802 may be configured to receive a radio frequency signal within a near-field communication range.

The near-field communication execution module 803 may be configured to perform, in a case where the radio frequency signal includes a signal from a near-field communication device within the near-field communication range in response to the emitted carrier signal, near-field communication with the near-field communication device. Herein, "a signal from a near-field communication device within the near-field communication range in response to the emitted carrier signal" may include: a signal obtained by reflecting the carrier signal by the near-field communication device within the near-field communication range (i.e., a reflecting signal of the carrier signal reflected by the near-field communication device), or a signal transmitted by the near-field communication device in response to the transmitted carrier signal, etc.

The explanations of terms such as the carrier signal may be referred to the descriptions in the above method embodiments and are not repeated here. The functional implementation of each module may also be referred to the descriptions in the above method embodiments.

In some embodiments, the carrier signal may be an unmodulated carrier signal.

In some embodiments, the carrier signal transmission module 801 may include a periodic signal transmission unit configured to periodically emit the carrier signal of the preset frequency.

In some embodiments, in a case where the near-field communication device only supports a card emulation function, the near-field communication execution module 803 may include a first near-field communication execution unit configured to enter a card reading mode to perform near-field communication with the near-field communication device.

In some embodiments, in a case where the near-field communication device supports both the card emulation function and the card reading function, the near-field communication execution module 803 may include a second near-field communication execution unit configured to enter a card emulation mode or a card reading mode to perform the near-field communication with the near-field communication device.

In some embodiments, the preset frequency may be a frequency outside a preset frequency range. The preset frequency range may be a frequency range configured to trigger the near-field communication device to interrupt the transmission of the near-field communication signal.

In some embodiments, the preset frequency may be multiple times the near-field communication frequency.

In some embodiments, the carrier signal transmission module 801 may further include a carrier signal transmission unit configured to transmit the carrier signal based on a first link. An impedance of the first link may match the preset frequency.

In some embodiments, the near-field communication execution module 803 may further include an NFC signal transceiver unit configured to transmit or receive the near-field communication signal based on a second link. An impedance of the second link may match the near-field communication frequency.

In some embodiments, the carrier signal transmission module 801 may further include a carrier signal triggering-executing unit configured to transmit the carrier signal of the preset frequency in a case where the preset page is entered.

The various modules in the above near-field communication apparatus may be implemented entirely or partially by software, hardware, and combinations thereof. The above modules may be embedded in the form of hardware in or independent of the processor of the computer device, or may be stored in the form of software in the memory of the computer device, so that the processor may call and execute the operations corresponding to the above modules. The near-field communication apparatus may also include other modules or units to perform other blocks or operations in the above method embodiments.

In some embodiments, as shown in FIG. 9, a radio frequency chip 10 is provided. The radio frequency chip 10 may be configured with a first terminal a and a second terminal b. The radio frequency chip 10 may include a multi-stage frequency divider 11, a first switching module 12, and a processing circuit 13.

An input terminal of the multi-stage frequency divider 11 may be connected to the first terminal a of the radio frequency chip to receive an external clock signal. The multi-stage frequency divider 11 may include a first frequency divider 111 at a stage and a second frequency divider 112 at another different stage. A frequency of a first clock signal output by the first frequency divider 111 may match a preset frequency. A frequency of a second clock signal output by the second frequency divider 112 may match the near-field communication frequency. A first input terminal of the first switching module 12 may be connected to the first frequency divider 111, and a second input terminal of the first switching module 12 may be connected to the second frequency divider 112. An input terminal of the processing circuit 13 may be connected to an output terminal of the first switching module 12, and an output terminal of the processing circuit 13 may be connected to the second terminal b of the radio frequency chip. The processing circuit 13 may be configured to support outputting the carrier signal of the preset frequency based on the first clock signal, outputting the near-field communication signal based on the second clock signal, and receiving the radio frequency signal.

The multi-stage frequency divider 11 may include at least two cascaded frequency dividers. The frequency dividers at different stages may output signals with different frequencies, and the frequencies may be in a multiple relationship. By inducing the clock signals with different frequencies from the first frequency divider 111 at a stage and the second frequency divider 112 at another different stage, and inputting the clock signal from the first frequency divider 111 to the first input terminal of the first switching module 12 and the clock signal from the second frequency divider 112 to the second input terminal of the first switching module 12, combined with the conduction path switching of the first switching module 12, the processing circuit 13 may generate two signals with different frequencies, which may be the carrier signal and the near-field communication signal. As shown in FIGS. 9-11, the processing circuit 13 may transmit the two signals to the antenna 30 via the matching circuit 20, and radiate the two signals into a space through the antenna 30 to achieve the transmission of the corresponding carrier signal or the corresponding near-field communication signal.

In a case where the NFC is needed to be performed, the first input terminal and the output terminal of the first switching module 12 may be conducted. In this case, the first clock signal of the corresponding frequency may be transmitted to the processing circuit 13 via the first switching module 12. The processing circuit 13, under the excitation of the first clock signal, may generate a multiple-frequency signal of the near-field communication signal as the carrier signal, and transmit the carrier signal to the matching circuit 20. After impedance matching by the matching circuit 20, the carrier signal may be transmitted via the antenna 30 to detect whether a near-field communication device is approaching within the near-field communication range.

In a case where the near-field communication signal is needed to be transmitted, the second input terminal and the output terminal of the first switching module 12 may be conducted. In this case, the second clock signal corresponding to the near-field communication signal may be transmitted to the processing circuit 13 by the first switching module 12. The processing circuit 13, under the excitation of the second clock signal, may generate the near-field communication signal and transmit the near-field communication signal to the matching circuit 20. After impedance matching by the matching circuit 20, the near-field communication signal may be transmitted via the antenna 30 to achieve the NFC with the near-field communication device.

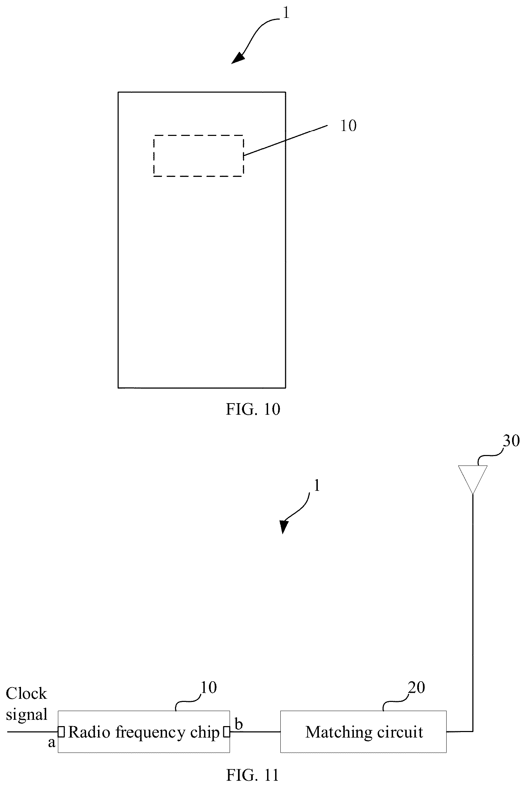

In some embodiments, as shown in FIG. 10, an electronic device 1 is provided. The electronic device 1 may include the radio frequency chip 10 described in the above embodiment.

The electronic device 1 equipped with the above radio frequency chip 10, when the NFC is needed to be performed, may transmit the carrier signal with the frequency different from the near-field communication frequency and receive the radio frequency signal to detect whether a near-field communication device is approaching within the near-field communication range thereof. Therefore, the detection of the near-field communication device may be achieved, and the carrier signal may not be identified as the near-field communication signal by the near-field communication device within the near-field communication range. The risk of interrupting the NFC field intensity and the command transmission being performed by the near-field communication device may be reduced. Thus, there is no need to wait for the time slot. Based on this, in a case where a near-field communication device is identified within the near-field communication range, the device may quickly perform the near-field communication with the near-field communication device, with high near-field communication efficiency and fast response speed.

In some embodiments, the electronic device 1 is configured to execute the blocks or operations of the near-field communication method described in the above embodiments.

By executing the blocks or operations of the above near-field communication method, the electronic device 1 may detect whether a near-field communication device is approaching within the near-field communication range thereof based on the carrier signal, and the carrier signal may not be identified as the near-field communication signal by the near-field communication device within the near-field communication range. In this way, the electronic device 1 may establish the NFC with the near-field communication device within the near-field communication range without interrupting the transmission of the NFC field intensity and the command of the near-field communication device. Besides, the NFC response speed may be fast, and the near-field communication efficiency may be high.

The electronic device 1 provided in some embodiments of the present disclosure may also execute other blocks or operations in the above method embodiments and achieve corresponding effects, which are not repeated here.

In some embodiment, as shown in FIGS. 11-12, in a case where the electronic device 1 includes the radio frequency chip 10, the electronic device 1 may further include an antenna 30 and a matching circuit 20.

The matching circuit 20 may be configured to support the preset frequency and the near-field communication frequency. The matching circuit 20 may be connected between the second terminal b of the radio frequency chip 10 and the antenna 30 to support the transmission and reception of the carrier signal and the near-field communication signal.

The matching circuit 20 may be configured to perform impedance matching on the radio frequency signal transmitted by the radio frequency chip 10 and the radio frequency signal received by the antenna 30, to improve the quality of radio frequency signal transmission and reception. In some embodiments, a filter circuit (not shown) may be connected in series between the matching circuit 20 and the radio frequency chip 10. The filter circuit may be configured to filter out other interference signals except the radio frequency signal to be supported at the current moment. The filter circuit may be an LC filter circuit. The matching circuit 20 may be implemented by one or more of capacitors, inductors, and resistors.

When the NFC is needed to be performed, the radio frequency chip 10 may output the carrier signal of the preset frequency. The carrier signal may be transmitted to the antenna 30 via the matching circuit 20. The carrier signal may be further radiated outward via the antenna 30 to achieve the transmission of the carrier signal. The radio frequency signal received via the antenna 30 may enter the radio frequency chip 10 through the matching circuit 20. The radio frequency chip 10 may identify whether a near-field communication device is approaching based on the received radio frequency signal. When there is an approaching near-field communication device, the radio frequency chip 10 may perform the near-field communication with the near-field communication device.

In a case where the near-field communication device only supports the card emulation function, the radio frequency chip 10 may enter the card reading mode, and the radio frequency chip 10 may read or write data of the near-field communication device.

In a case where the near-field communication device supports both the card emulation function and the card reading function, the radio frequency chip 10 may adopt a polling working method between the card reading mode and the card emulation mode until the NFC is established with the near-field communication device.

In some embodiments, the matching circuit may be a multi-frequency point resonant circuit. The multi-frequency point resonant circuit may be configured to support the preset frequency and the near-field communication frequency.

The multi-frequency resonant circuit may both support the preset frequency and the near-field communication frequency. During process of switching between transmitting the near-field communication signal and transmitting the carrier signal, impedance matching on the transmission link may be achieved without needing to add a switching module, thereby reducing hardware costs.

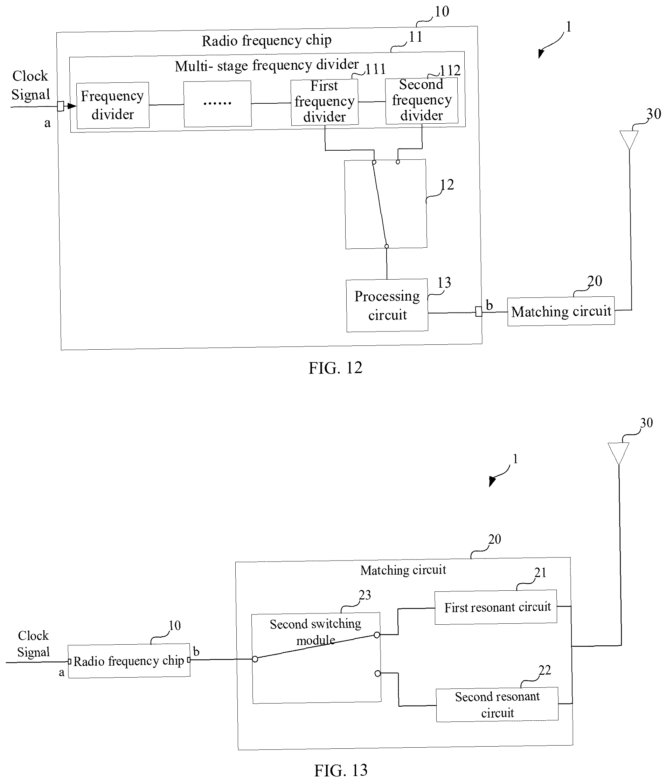

In some embodiments, as shown in FIGS. 13-14, the matching circuit 20 may include a first resonant circuit 21, a second resonant circuit 22, and a second switching module 23.

A resonant frequency point of the first resonant circuit 21 may match the preset frequency. A first terminal of the first resonant circuit 21 may be connected to the antenna 30. A resonant frequency point of the second resonant circuit 22 may match the near-field communication frequency. A first terminal of the second resonant circuit 22 may be connected to the antenna 30. A first terminal of the second switching module 23 may be connected to a second terminal of the first resonant circuit 21. A second terminal of the second switching module 23 may be connected to a second terminal of the second resonant circuit 22. A third terminal of the second switching module 23 may be connected to the second terminal b of the radio frequency chip 10.

By separately setting two resonant circuits and cooperating with the second switching module 23, in two cases where the radio frequency chip 10 outputs the carrier signal and the near-field communication signal respectively, the impedance matching for signal transmission in the corresponding frequency bands may be performed separately, thereby improving communication quality.

For example, in a case where the radio frequency chip 10 outputs the carrier signal, the second switching module 23 may be switched to enable the first resonant circuit 21 and the radio frequency chip 10 to be conducted. The carrier signal may be transmitted to the antenna 30 after impedance matching by the first resonant circuit 21, and electromagnetic waves may be radiated by the antenna 30 to achieve the transmission of the carrier signal.

In a case where the radio frequency chip 10 outputs the near-field communication signal, the second switching module 23 may be switched to enable the second resonant circuit 22 and the radio frequency chip 10 to be conducted. The near-field communication signal may be transmitted to the antenna 30 after impedance matching by the second resonant circuit 22, and electromagnetic waves may be radiated by the antenna 30 to achieve the transmission of the carrier signal.

In a case where the electronic device 1 receives a near-field communication signal, the second switching module 23 may be switched to enable the second resonant circuit 22 and the radio frequency chip 10 to be conducted. The near-field communication signal received by the antenna 30 may be transmitted to the radio frequency chip 10 after impedance matching by the second resonant circuit 22 to achieve the reception of the near-field communication signal.

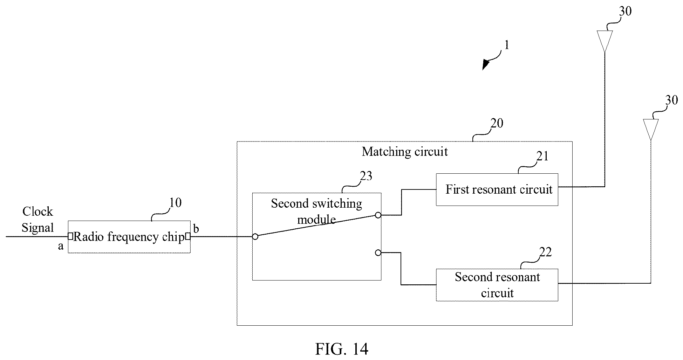

The first resonant circuit 21 and the second resonant circuit 22 may share one antenna 30 as shown in FIG. 13, or may be connected to different antennas 30 as shown in FIG. 14. Sharing the same antenna 30 by the first resonant circuit 21 and the second resonant circuit 22 may reduce hardware costs.

In some embodiments, the second switching module 23 may be integrated into the radio frequency chip 10. In this way, it is possible to reduce signal loss during transmission and reduce the volume of the electronic device 1.

In some embodiments, a computer-readable storage medium is provided. The computer-readable storage medium may store a computer program. When the computer program is executed by a processor, the blocks or the operations of the above near-field communication method are implemented, and the corresponding effects may be achieved, which are not repeated here.

In some embodiments, a computer program product is provided. The computer program product may include a computer program. When the computer program is executed by a processor, the blocks or operations of the above near-field communication method may be implemented, and the corresponding effects may be achieved, which are not repeated here.

Those skilled in the art can understand that all or part of the processes in the methods of the above embodiments can be implemented by instructing relevant hardware through a computer program. The computer program may be stored in a non-volatile computer-readable storage medium. When the computer program is executed, the computer program may execute the operations of some embodiments of the above methods. Any reference to memory, database, or other media in some embodiments of the present disclosure may include at least one of non-volatile memory and volatile memory. The non-volatile memory may include read-only memory (ROM), magnetic tape, floppy disk, flash memory, optical memory, high-density embedded non-volatile memory, resistive random access memory (ReRAM), magnetoresistive random access memory (MRAM), ferroelectric random access memory (FRAM), phase change memory (PCM), graphene memory, etc. The volatile memory may include random access memory (RAM) or external cache memory, etc. As an illustration but not a limitation, RAM may be in various forms, such as static random access memory (SRAM) or dynamic random access memory (DRAM), etc. The databases involved in some embodiments of the present disclosure may include at least one of relational databases and non-relational databases. The non-relational database may include a blockchain-based distributed database, etc., which is not limited thereto. The processors involved in some embodiments of the present disclosure may be general-purpose processors, central processing units, graphics processing units, digital signal processors, programmable logic devices, data processing logic devices based on quantum computing, artificial intelligence (AI) processors, etc., which are not limited thereto.

The various technical features in the above embodiments may be combined arbitrarily. For the sake of concise description, not all possible combinations of the various technical features in the above embodiments are described. However, they should be considered as the scope described in the present disclosure when there is no contradiction in the combination of these technical features.

## Claims

1. A near-field communication method, **characterized by** comprising:
transmitting (S201) a carrier signal of a preset frequency, wherein the preset frequency is different from a near-field communication frequency;
receiving (S202) a radio frequency signal within a near-field communication range; and
performing (S203), in a case where the radio frequency signal comprises a signal from a near-field communication device within the near-field communication range in response to the transmitted carrier signal, near-field communication with the near-field communication device.

2. The method as claimed in claim 1, wherein the carrier signal is an unmodulated carrier signal.

3. The method as claimed in claim 1, wherein in a case where the near-field communication device only supports a card emulation function, the performing (S203) the near-field communication with the near-field communication device, comprises:
entering (S401) a card reading mode to perform the near-field communication with the near-field communication device.

4. The method as claimed in claim 1, wherein in a case where the near-field communication device supports a card emulation function and a card reading function, the performing (S203) the near-field communication with the near-field communication device, comprises:
entering (S402) a card emulation mode or a card reading mode to perform near-field communication with the near-field communication device.

5. The method as claimed in claim 1, wherein the preset frequency is a frequency outside a preset frequency range, and the preset frequency range is a frequency range configured to trigger the near-field communication device to interrupt a transmission of a near-field communication signal.

6. The method as claimed in claim 5, wherein the preset frequency is multiple times the near-field communication frequency.

7. The method as claimed in any one of claims 1-6, wherein the transmitting (S201) the carrier signal of the preset frequency, comprises:
transmitting (S701) the carrier signal of the preset frequency in a case where a preset page is entered.

8. The method as claimed in claim 1, wherein the transmitting (S201) the carrier signal of the preset frequency, comprises:
periodically transmitting (S301) the carrier signal of the preset frequency.

9. The method as claimed in claim 1, wherein the transmitting (S201) the carrier signal of the preset frequency, further comprises: transmitting (S501) the carrier signal based on a first link, wherein an impedance of the first link matches the preset frequency; or
wherein the performing (S203) the near-field communication with the near-field communication device, further comprises: transmitting (S601) or receiving a near-field communication signal based on a second link, wherein an impedance of the second link matches the near-field communication frequency.

10. A radio frequency chip (10), configured with a first terminal (a) and a second terminal (b), **characterized in that** the radio frequency chip (10) comprises:
a multi-stage frequency divider (11), wherein an input terminal of the multi-stage frequency divider (11) is connected to the first terminal (a) of the radio frequency chip (10) to receive an external clock signal, the multi-stage frequency divider (11) comprises a first frequency divider (111) at a stage and a second frequency divider (112) at another different stage, a frequency of a first clock signal output by the first frequency divider (111) matches a preset frequency, and a frequency of a second clock signal output by the second frequency divider (112) matches a near-field communication frequency;
a first switching module (12), wherein a first input terminal of the first switching module (12) is connected to the first frequency divider (111) and a second input terminal of the first switching module (12) is connected to the second frequency divider (112); and
a processing circuit (13), wherein an input terminal of the processing circuit (13) is connected to an output terminal of the first switching module (12), an output terminal of the processing circuit (13) is connected to the second terminal (b) of the radio frequency chip (10), and the processing circuit (13) is configured to support outputting the carrier signal of the preset frequency based on the first clock signal, support receiving a radio frequency signal within a near-field communication range, and support outputting, in a case where the radio frequency signal comprises a signal from a near-field communication device within the near-field communication range in response to the carrier signal, a near-field communication signal based on the second clock signal, wherein the near-field communication signal is configured for near-field communication with the near-field communication device.

11. An electronic device (1), **characterized in that** the electronic device (1) comprises the radio frequency chip (10) as claimed in claim 10; or the electronic device (1) is configured to execute operations of the method as claimed in any one of claims 1-9.

12. The electronic device (1) as claimed in claim 11, wherein in a case where the electronic device (1) comprises the radio frequency chip (10), the electronic device (1) further comprises:
an antenna (30); and
a matching circuit (20), wherein the matching circuit (20) is configured to support the preset frequency and the near-field communication frequency, and the matching circuit (20) is connected between the second terminal (b) of the radio frequency chip (10) and the antenna (30), to support transmission and reception of the carrier signal and the near-field communication signal.

13. The electronic device (1) as claimed in claim 12, wherein the matching circuit (20) is a multi-frequency point resonant circuit, and the multi-frequency point resonant circuit is configured to support the preset frequency and the near-field communication frequency.

14. The electronic device (1) as claimed in claim 12, wherein the matching circuit (20) comprises:
a first resonant circuit (21), wherein a resonant frequency point of the first resonant circuit (21) matches the preset frequency, and a first terminal of the first resonant circuit (21) is connected to the antenna (30);
a second resonant circuit (22), wherein a resonant frequency point of the second resonant circuit (22) matches the near-field communication frequency, and a first terminal of the second resonant circuit (22) is connected to the antenna (30); and
a second switching module (23), wherein a first terminal of the second switching module (23) is connected to a second terminal of the first resonant circuit (21), a second terminal of the second switching module (23) is connected to a second terminal of the second resonant circuit (22), and a third terminal of the second switching module (23) is connected to the second terminal (b) of the radio frequency chip (10).

15. A computer-readable storage medium, storing a computer program, **characterized in that** when executed by a processor, the computer program is configured to execute the operations of the method as claimed in any one of claims 1-9.
